# EUROPEAN PATENT SPECIFICATION

(11) **EP 1 650 790 B1**
(45) Date of publication and mention of the grant of the patent: **28.04.2010**
(21) Application number: 04747098.4
(22) Date of filing: 07.07.2004
(51) Int. Cl.: H01L 21/301, H01L 21/52, C09J 7/02

(54) **HARDENABLE PRESSURE SENSITIVE ADHESIVE SHEET FOR DICING/DIE-BONDING AND METHOD FOR MANUFACTURING SEMICONDUCTOR DEVICE**
HÄRTBARE SELBSTKLEBEFOLIE ZUM ZERTRENNEN BZW. CHIP-BONDEN UND VERFAHREN ZUR HERSTELLUNG EINES HALBLEITERBAUELEMENTS
FEUILLE AUTO-ADHESIVE DURCISSABLE POUR DECOUPAGE EN PUCES/FIXATION DE PUCES, ET PROCEDE DE FABRICATION DE DISPOSITIF A SEMICONDUCTEUR

(30) Priority: 08.07.2003 JP 2003271950
(43) Date of publication of application: 26.04.2006
(73) Proprietor: Lintec Corporation, Tokyo 173-0001 (JP)
(72) Inventor: SAIKI, Naoya, 3430806 (JP)
(74) Representative: Piésold, Alexander James
(86) International application number: PCT/JP2004/009629
(87) International publication number: WO 2005/004216

(56) References cited:
- WO-A-03/017363
- JP-A- 2002 226 796
- JP-A- 2004 039 928

## Description

### FIELD OF THE INVENTION

The present invention relates to a novel dicing and die bonding pressure-sensitive adhesive sheet. More particularly, the invention relates to a dicing and die bonding pressure-sensitive adhesive sheet that is particularly suitable for use in the process of dicing a silicon wafer or the like and bonding the resultant dice onto die pads of a substrate such as a lead frame.

### BACKGROUND OF THE INVENTION

Large-diameter semiconductor wafers such as silicon or gallium arsenide wafers are cut (diced) into elements (IC chips) and thereafter mounted. In this process, the semiconductor wafer is beforehand stuck on a pressure-sensitive adhesive tape, and subsequently diced, washed and dried. Thereafter, the tape is expanded, and the chips are picked up and bonded.

To simplify the pick up step and the bonding step, various proposals have been made on dicing and die bonding pressure-sensitive adhesive sheets that can function both to fix the wafer and to bond the dice (see JP-A-H02-32181, JP-A-H08-239636 and JP-A-H10-8001).

These patent documents disclose pressure-sensitive adhesive sheets comprising a base material and a pressure-sensitive adhesive layer which is composed of a specific composition. The pressure-sensitive adhesive layers work to fix the wafer in the wafer dicing. The adhesion thereof with respect to the base material is controllable. Therefore, when the chips are picked up after the dicing, the pressure-sensitive adhesive layer can be removed from the base material together with the chips picked up. The IC chips on which the pressure-sensitive adhesive layer is adhered are then mounted on a substrate and heated. As a result, a thermosetting resin contained in the pressure-sensitive adhesive layer produces adhesion and the IC chips are boned on the substrate.

The pressure-sensitive adhesive sheets disclosed in the above Patent Documents allow elimination of the application of a die bonding adhesive and thereby enable the so-called direct die bonding. That is, the pressure-sensitive adhesive layers of the pressure-sensitive adhesive sheets can achieve very firm adhesion between the chips and the substrate as a result of curing of all the components through energy ray irradiation and heat in the die bonding.

Meanwhile, recent IC package structures have great variation. This has demanded diverse requirements on properties depending on the structures. For example, structures of die pads on which the chips are mounted have been diversified and often have irregularities caused by copper wiring or solder resists. The hight difference caused by irregularities may be about 5 to 20µm. When the die pads have such great height differences, the mounting of chips through the pressure-sensitive adhesive layer occasionally results in voids between the die pads and the pressure-sensitive adhesive layer because the pressure-sensitive adhesive fails to densely embed the irregularities on the die pads.

The voids may cause cracks in a thermal cycle test or a humidity test, and production efficiency is lowered.

### OBJECTS OF THE INVENTION

The present invention has been made in view of the background as described above. Therefore, it is an object of the invention to provide a dicing and die bonding pressure-sensitive adhesive sheet that has a pressure-sensitive adhesive layer exhibiting excellent embedding properties in die bonding and thereby can prevent formation of voids between die pads and the pressure-sensitive adhesive layer even when chips are mounted on the die pads having great height difference.

### DISCLOSURE OF THE INVENTION

WO 03/017363 A discloses a dicing and die bonding pressure-sensitive adhesive sheet according to the present invention comprises a base material and a pressure-sensitive adhesive layer disposed thereon.

To address the problems in the art discussed above, the invention provides a dicing and die bonding pressure-sensitive adhesive sheet in which, in addition, the pressure-sensitive adhesive layer has a ratio (M₁₀₀/M₇₀) of a modulus of elasticity at 100 °C (M₁₀₀) to a modulus of elasticity at 70 °C (M₇₀) being 0.5 or less, wherein the pressure-sensitive adhesive layer comprises a pressure-sensitive component and a thermosetting component, the pressure-sensitive component comprising an acrylic polymer having a weight-average molecular weight of 30,000 to 500,000, and wherein the acrylic polymer contains repeating units derived from vinyl acetate in an amount of 5 to 50% by mass.

The pressure-sensitive adhesive layer preferably contains a thermoplastic resin having a glass transition temperature of 60 to 150 °C. The weight ratio of the acrylic polymer and the thermoplastic resin (acrylic polymer/thermoplastic resin) preferably ranges from 9/1 to 3/7.

The base material preferably has a surface tension of 40 mN/m or less at a surface which contacts with the pressure-sensitive adhesive layer.

A process for producing semiconductor devices according to the present invention comprises sticking a semiconductor wafer onto the pressure-sensitive adhesive layer of the dicing and die bonding pressure-sensitive adhesive sheet, dicing the semiconductor wafer into IC chips, picking up the IC chips from the base material while allowing the pressure-sensitive adhesive layer to remain adhered to the IC chips, and bonding the IC chips onto die pads by means of the pressure-sensitive adhesive layer with the application of heat and pressure.

### EFFECT OF THE INVENTION

In the dicing and die bonding pressure-sensitive adhesive sheet of the invention, the pressure-sensitive adhesive layer displays superior embedding properties with respect to irregularities on the die pads under die bonding conditions. Therefore, voids often formed between the die pads and the pressure-sensitive adhesive layer can be prevented even when the chips are mounted on the die pads having great difference of elevation, and product efficiency may be increased.

### PREFERRED EMBODIMENTS OF THE INVENTION

Hereinbelow, the present invention will be described in greater detail.

The dicing and die bonding pressure-sensitive adhesive sheet according to the present invention comprises a base material and a pressure-sensitive adhesive layer disposed thereon. The pressure-sensitive adhesive layer has a ratio (M₁₀₀/M₇₀) between moduli of elasticity at 100°C (M₁₀₀) and at 70°C (M₇₀) being 0.5 or less, preferably 0.4 or less, and more preferably from 0.1 to 0.3.

The lower limit of the modulus of elasticity at 70°C (M₇₀) is preferably 5000 Pa, and more preferably 6000 Pa. On the other hand, the upper limit of the modulus of elasticity at 100°C (M₁₀₀) is preferably 4000 Pa, and more preferably 3000 Pa.

The pressure-sensitive adhesive layer has both adhesion and thermosetting properties. The above-mentioned moduli of elasticity are ones determined prior to thermosetting. In one embodiment of the invention, the pressure-sensitive adhesive layer may also have energy ray curing properties. In such embodiment, the above moduli of elasticity refer to ones determined between energy ray curing and thermosetting.

As described hereinabove, the pressure-sensitive adhesive layer has a modulus of elasticity at 100°C remarkably lower than that at 70°C. This indicates that the pressure-sensitive adhesive layer becomes fluidized at high temperatures. Die bonding of semiconductor chips is generally performed at elevated temperatures, usually 100°C or above, and other work at ordinary temperatures. Accordingly, the pressure-sensitive adhesive layer is fluidized under die bonding conditions and can densely embed into irregularities on the die pads, thereby preventing voids. On the other hand, at low temperatures the pressure-sensitive adhesive layer maintains a certain level of modulus of elasticity and firmly adheres to the chips. Therefore, good workability is ensured throughout the steps from dicing to picking up.

The pressure-sensitive adhesive layer essentially consists of a pressure-sensitive component (A) and a thermosetting component (B), and may further contain a thermoplastic resin (C). Furthermore, an energy ray curing component (D) and a further additive (E) may be optionally added.

Hereinbelow, the components (A) to (E) will be described.

### [Pressure-sensitive component (A)]

The pressure-sensitive component (A) is preferably an acrylic polymer. The repeating units of the acrylic polymer include those derived from (meth)acrylate monomers and (meth)acrylic acid derivatives. The (meth)acrylate monomers include cycloalkyl (meth)acrylates, benzyl (meth)acrylates and alkyl (meth)acrylates in which the alkyl groups have 1 to 18 carbon atoms. Of these, particularly preferred are the alkyl (meth)acrylates in which the alkyl groups have 1 to 18 carbon atoms, such as methyl acrylate, methyl methacrylate, ethyl acrylate, ethyl methacrylate, propyl acrylate, propyl methacrylate, butyl acrylate and butyl methacrylate. The (meth)acrylic acid derivatives include glycidyl (meth)acrylate.

In particular, a copolymer containing glycidyl (meth)acrylate units and units of at least one kind of alkyl (meth)acrylates is preferred. In this case, the copolymer may contain 0 to 80% by mass, preferably 5 to 50% by mass of the structural units derived from glycidyl (meth)acrylate. Introduction of the glycidyl group leads to improved compatibility with an epoxy resin used as the thermosetting component (mentioned later), and also to a higher glass transition temperature (Tg) and higher heat resistance of the cured product. Of the alkyl (meth)acrylates, methyl (meth)acrylate, ethyl (meth)acrylate and butyl (meth)acrylate are preferred. Furthermore, a hydroxyl group-containing monomer such as hydroxyethyl acrylate may be introduced to enable easy control of adhesion and pressure sensitivity with respect to the adherends.

The acrylic polymer ranges in weight-average molecular weight from 30,000 to 500,000, preferably from 40,000 to 400,000, and more preferably from 50,000 to 300,000. When the weight-average molecular weight of the acrylic polymer is low, the ratio M₁₀₀/M₇₀ can be set small.

However, low weight-average molecular weight of the acrylic polymer more likely leads to deterioration of application properties of a coating solution of the pressure-sensitive adhesive layer. One example is formation of pinholes.

Therefore, the acrylic polymer preferably contains vinyl acetate units in part of the repeating units of the main chain. When the acrylic polymer contains vinyl acetate repeating units, the coating solution for forming the pressure-sensitive adhesive layer can exhibit improved application properties to prevent pinholes. The vinyl acetate repeating units is contained in an amount of 5 to 50% by mass, more preferably 7.5 to 40% by mass, and particularly preferably 10 to 30% by mass of the acrylic polymer.

### [Thermosetting component (B)]

The thermosetting component (B) has a nature such that it is not cured by energy rays and it forms three-dimensional network upon heating to firmly bond the adherends. The thermosetting components (B) generally comprise a thermosetting resin such as epoxy, phenol, resorcinol, urea, melamine, furan, unsaturated polyester or silicone, and an appropriate curing accelerator. Many such thermosetting components are known and the invention can use any of them without limitation. One example of the thermosetting components is a combination of an epoxy resin (B-1) and a latent heat activatable epoxy resin-curing agent (B-2).

The epoxy resin (B-1) may be selected from the epoxy resins conventionally known, and preferably ranges in weight-average molecular weight from about 300 to 2000. Particularly preferred is a blend of a liquid epoxy resin at ordinary condition having a weight-average molecular weight of 300 to 500, preferably 330 to 400, and a solid epoxy resin at ordinary condition having a weight-average molecular weight of 400 to 2000, preferably 500 to 1500. The epoxy resin of suitable use in the invention generally has an epoxy equivalent of 50 to 5000 g/eq. Specific examples of the epoxy resins include glycidyl ethers of phenols such as of bisphenol A, bisphenol F, resorcinol, phenyl novolak and cresol novolak; glycidyl ethers of alcohols, such as of butanediol, polyethylene glycol and polypropylene glycol; glycidyl esters of carboxylic acids, such as of phthalic acid, isophthalic acid and tetrahydrophthalic acid; glycidyl- or alkylglycidyl-substituted epoxy resins obtained from aniline isocyanurate and the like by substituting the active hydrogen bonded to a nitrogen atom with a glycidyl group; and so-called alicyclic epoxides in which an epoxy group is introduced by, for example, oxidizing a carbon-carbon double bond in the molecule, such as vinylcyclohexene diepoxide, 3,4-epoxycyclohexylmethyl-3,4-dicyclohexane carboxylate and 2-(3,4-epoxy)cyclohexyl-5,5-spiro(3,4-epoxy) cyclohexane-m-dioxane. Also useful are dicyclopentadiene skeleton-containing epoxy resins whose molecule contains a dicyclopentadiene skeleton and a reactive epoxy group.

Of the above epoxy resins, the bisphenol-based glycidyl epoxy resins, o-cresol novolak-based epoxy resins and phenol novolak-based epoxy resins are preferable.

The epoxy resins may be used singly or in combination of two or more kinds.

The latent heat activatable epoxy resin-curing agent (B-2) is of a type such that it does not react with the epoxy resin at room temperature but does react by being activated at or above a certain elevated temperature.

Various methods are employable to activate the latent heat-activatable epoxy resin-curing agent (B-2).

The activation of the latent heat-activatable epoxy resin-curing agent (B-2) can be accomplished by various methods, for example, the method wherein active species (anion and cation) are formed by chemical reaction induced by heating; the method wherein the latent heat-activatable epoxy resin-curing agent (B-2) is stably dispersed in the epoxy resin (B-1) at about room temperature, but at high temperatures, is dissolved in the epoxy resin (B-1) to thereby initiate a curing reaction; the method wherein the curing agent is enclosed in a molecular sieve and is leached at high temperatures to thereby initiate a curing reaction; and the method wherein use is made of microcapsules.

The heat-activatable latent epoxy resin-curing agents may be used singly or in combination of two or more kinds. Preferred curing agents include dicyandiamide, imidazol compounds, and mixtures thereof.

The latent heat-activatable epoxy resin-curing agent (B-2) is generally used in an amount of 0.1 to 20 parts by mass, preferably 0.5 to 15 parts by mass, and particularly preferably 1 to 10 parts by mass based on 100 parts by mass of the epoxy resin (B-1).

The thermosetting component (B) is preferably used in an amount of 10 to 97 parts by mass, more preferably 30 to 95 parts by mass, and particularly preferably 50 to 90 parts by mass based on 100 parts by mass of the sum of the pressure-sensitive component (A) and thermosetting component (B) ((A)+(B)).

When the weight ratio (A)/(B) is low, the ratio M₁₀₀/M₇₀ can be set small.

### [Thermoplastic resin (C)]

The ratio M₁₀₀/M₇₀ can be set small also by incorporating in the pressure-sensitive adhesive layer a thermoplastic resin that has a glass transition temperature of 60 to 150°C. Examples of the thermoplastic resins include polyester resins, polyvinyl alcohol resins, polyvinyl butyrals, polyvinyl chlorides, polystyrenes, polyamide resins, celluloses, polyethylenes, polyisobutylenes, polyvinyl ethers, polyimide resins, phenoxy resins, polymethyl methacrylates, styrene/isoprene/styrene block copolymers and styrene/butadiene/styrene block copolymers. Of these, the phenoxy resins are particularly preferable due to excellent compatibility with the other components of the pressure-sensitive adhesive layer.

The thermoplastic resin (C) is preferably incorporated in the pressure-sensitive adhesive layer in an amount of 1 to 50 parts by mass, more preferably 2 to 40 parts by mass, and particularly preferably 3 to 30 parts by mass based on 100 parts by mass of the sum of the pressure-sensitive component (A) and thermosetting component (B). When the pressure-sensitive component (A) is the acrylic polymer, the acrylic polymer and the thermoplastic resin preferably have a weight ratio (acrylic polymer/thermoplastic resin) of 9/1 to 3/7. High proportion of the thermoplastic resin (C) in the pressure-sensitive adhesive layer leads to lowering of the ratio M₁₀₀/M₇₀.

### [Energy ray curing component (D)]

The pressure-sensitive adhesive layer may optionally contain an energy ray curing component (D). Curing of the energy ray curing component (D) can decrease the adhesion of the pressure-sensitive adhesive layer. Therefore, the pressure sensitive adhesion layer can be easily separated from the base material.

The energy ray curing component (D) is a compound that is polymerized and cured upon irradiation with energy rays such as ultraviolet rays or electron beams. Specific examples of the energy ray polymerizable compounds include acrylate compounds such as trimethylolpropane triacrylate, tetramethylolmethane tetraacrylate, pentaerythritol triacrylate, dipentaerythritol monohydroxypentaacrylate, dipentaerythritol hexaacrylate, 1,4-butyleneglycol diacrylate, 1,6-hexanediol diacrylate, polyethyleneglycol diacrylate, oligoester acrylate, urethane acrylate oligomers, epoxy-modified acrylates, polyether acrylate and itaconic acid oligomers. These compounds have at least one polymerizable double bond in the molecule and generally range in weight-average molecular weight from about 100 to 30000, and preferably from about 300 to 10000.

Further examples of the energy ray polymerizable compounds are those compounds having a dicyclopentadiene skeleton.

The energy ray curing component (D) is used in an approximate amount of 0 to 50 parts by mass, preferably 0 to 30 parts by mass, and particularly preferably 5 to 20 parts by mass based on 100 parts by mass of the total of the components (A) and (B).

When the pressure-sensitive adhesive composition contains the energy ray curing component (D), the composition is irradiated with energy rays to cure the curing component. The energy rays include ultraviolet rays and electron beams.

When the energy rays are ultraviolet rays, polymerization (curing) time and irradiation dose can be saved by use of a photopolymerization initiator.

The photopolymerization initiators include benzophenone, acetophenone, benzoin, benzoin methyl ether, benzoin ethyl ether, benzoin isopropyl ether, benzoin isobutyl ether, benzoinbenzoic acid, methylbenzoinbenzoate, benzoin dimethylketal, 2,4-diethylthioxanthone, α-hydroxycyclohexyl phenyl ketone, benzyl diphenyl sulfide, tetramethylthiuram monosulfide, azobisisobutyronitrile, benzil, dibenzil, diacetyl, β-chloroanthraquinone and 2,4,6-trimethylbenzoyldiphenylphosphine oxide.

The photopolymerization initiator is desirably used in an approximate amount of 0.01 to 20 parts by mass, and preferably 0.1 to 15 parts by mass based on 100 parts by mass of the energy ray curing component (D).

### [Further additive (E)]

The pressure-sensitive adhesive layer may contain a coupling agent (E1). The coupling agent (E-1) preferably contains a group capable of reacting with the functional groups in the components (A) to (D), preferably that in the component (B).

Presumably the functional group in the coupling agent (E1), which is specifically an organic functional group, reacts with the thermosetting component (B) (particularly preferably with the epoxy resin) in curing reaction. The obtainable results are enhancements in adhesion and clinginess of the cured product without deteriorating heat resistance, and also in water resistance (heat and humid resistance).

A silane coupling agent is a preferred coupling agent (E1) because of its versatility and cost merits. The coupling agent (E1) is generally used in an amount of 0.1 to 20 parts by mass, preferably 0.3 to 15 parts by mass, and particularly preferably 0.5 to 10 parts by mass based on 100 parts by mass of the thermosetting component (B).

Further, a crosslinking agent (E2) such as an organic polyvalent isocyanate or imine compound may be added to the pressure-sensitive adhesive layer in order to regulate the initial adhesion and cohesion strength thereof before exposure to energy ray irradiation.

Exemplary organic polyvalent isocyanate compounds include aromatic polyvalent isocyanate compounds, aliphatic polyvalent isocyanate compounds, alicyclic polyvalent isocyanate compounds, trimers of these polyvalent isocyanate compounds and isocyanato-terminated urethane prepolymers obtained by reaction of the polyvalent isocyanate compounds with polyol compounds. Specific examples of the organic polyvalent isocyanate compounds include 2,4-tolylene diisocyanate, 2,6-tolylene diisocyanate, 1,3-xylylene diisocyanate, 1,4-xylene diisocyanate, diphenylmethane-4,4'-diisocyanate, diphenylmethane-2,4'-diisocyanate, 3-methyldiphenylmethane diisocyanate, hexamethylene diisocyanate, isophorone diisocyanate, dicyclohexylmethane-4,4'-diisocyanate, dicyclohexylmethane-2,4'-diisocyanate and lysine isocyanate.

Exemplary organic polyvalent imine compounds include N,N'-diphenylmethane-4,4'-bis(1-aziridine carboxyamide), trimethylolpropane-tri-β-aziridinyl propionate, tetramethylolmethane-tri-β-aziridinyl propionate and N,N'-toluene-2,4-bis(1-aziridine carboxyamide) triethylenemelamine.

Furthermore, an electrically and thermally conductive filler may be incorporated in the pressure-sensitive adhesive layer to enable the cured layer to display electrical and thermal conductivity after the die bonding. Suitable fillers include gold, silver, copper, nickel, aluminum, stainless steel, carbon, ceramics and silver-coated nickel, aluminum and the like. Insulating fillers such as asbestos, silicas, glass, micas, chromium oxide, titanium oxide and pigments may be added. The filler may be used in an amount of about 0 to 400 parts by mass based on 100 parts by mass of the components (excluding the filler) of the pressure-sensitive adhesive layer.

### [Pressure-sensitive adhesive layer]

The pressure-sensitive adhesive layer comprises the aforesaid components and desirably ranges in thickness from 3 to 100 µm, and preferably from 5 to 60 µm.

The pressure-sensitive adhesive comprising the above components has both adhesion and thermosetting properties. Therefore, it can contribute to the fixing of a wafer by adhering to a base material in the dicing, and can be used as an adhesive to bond the chips and die pads in the mounting. Upon heating, the adhesive layer gives a cured product having high impact resistance. Moreover, the cured product is excellent in balance between shear strength and peeling strength and can maintain sufficient bonding properties even under severe hot and humid conditions.

### [Dicing and die bonding pressure-sensitive adhesive sheet]

The dicing and die binding pressure-sensitive adhesive sheet of the invention comprises a base material and the above pressure-sensitive adhesive layer disposed on the base material. The dicing and die binding pressure-sensitive adhesive sheet may have any forms, including tapes and labels.

The base material of the dicing and die binding pressure-sensitive adhesive sheet may be a transparent film. Examples thereof include polyethylene films, polypropylene films, polybutene films, polybutadiene films, polymethylpentene films, polyvinylchloride films, vinyl chloride copolymer films, polyethylene terephthalate films, polyethylene naphthalate films, polybutylene terephthalate films, polyurethane films, ethylene vinyl acetate films, ionomer resin films, ethylene/(meth)acrylic acid copolymer films, ethylene/(meth)acrylate copolymer films, polystyrene films, polycarbonate films, polyimide films, and crosslinked films and laminated films of these films. Further, colored (untransparent) films of the above transparent films, and fluororesin films are also employable.

In production of semiconductor devices with use of the dicing and die bonding pressure-sensitive adhesive sheet of the invention, the IC chips are picked up from the base material while allowing the pressure-sensitive adhesive layer to remain adhered to the back surface of the IC chips. Therefore, the surface of the base material that contacts with the pressure-sensitive adhesive layer preferably has a surface tension of 40 mN/m or less, more preferably 37 mN/m or less, and particularly preferably 35 mN/m or less. Such low surface tension of the base material can be obtained by appropriately selecting the base material or by coating the surface of the base material with a release agent.

Suitable release agents for the release coating on the base material include alkyd resins, silicone resins, fluororesins, unsaturated polyesters, polyolefins and waxes. The alkyd resins, silicone resins and fluororesins are particularly preferable release agents due to their high heat resistance. In particular, the alkyd resins are preferred because of high adhesion to the base material and easy control of the surface tension.

In the release treatment on the surface of the base material using the aforesaid release agent, the release agent may be applied directly in the absence of a solvent or as a dilute solution or an emulsion in a solvent, by means of a gravure coater, a Meyer bar coater, an air knife coater or a roll coater, followed by exposure to normal or elevated temperatures or electron beam irradiation to effect curing. Another method is lamination by, for example, wet lamination, dry lamination, thermolamination, extrusion lamination and coextrusion.

The base material generally has a thickness of about 10 to 500 µm, preferably about 15 to 300 µm, and particularly preferably about 20 to 250 µm.

The process for producing the dicing and die bonding pressure-sensitive adhesive sheet is not particularly limited. For example, the sheet may be produced by coating the base material with the pressure-sensitive adhesive composition, followed by drying. It is also appropriate to form the pressure-sensitive adhesive layer on a release film and transfer the layer onto the base material.

Before use of the dicing and die bonding pressure-sensitive adhesive sheet, a release film may be disposed on the pressure-sensitive adhesive layer for protective purpose.

The pressure-sensitive adhesive layer may have at its external peripheral portions another pressure-sensitive sheet for fixing a ring frame.

### [Method of using the dicing and die bonding pressure-sensitive adhesive sheet]

Hereinbelow, use of the dicing and die bonding pressure-sensitive adhesive sheet will be explained in the case of application in the production of semiconductor devices.

In the production process of semiconductor devices according to the invention, the dicing and die bonding pressure-sensitive adhesive sheet is fixed on a dicing machine by means of a ring frame. Thereafter, a silicon wafer is placed on the pressure-sensitive adhesive layer of the dicing and die bonding pressure-sensitive adhesive sheet, and light press is applied to secure the silicon wafer.

Subsequently, when the pressure-sensitive adhesive layer contains the energy ray curing component, energy rays are applied thereto through the base material. The irradiation increases the cohesion of the pressure-sensitive adhesive layer, so that the adhesion between the adhesive layer and the base material is lowered.

The silicon wafer is then cut by cutting means such as a dicing saw, and IC chips are produced. The cutting depth is determined in consideration of the thickness of the silicone wafer and pressure-sensitive adhesive layer, and abrasion of the dicing saw.

The above application of energy rays may be performed after the dicing, or even after the expanding step described below.

Where necessary, the dicing and die bonding pressure-sensitive adhesive sheet may be expanded to widen the distances between the IC chips, thereby facilitating the picking up of the IC chips. Also, the expansion causes slipping between the base material and the pressure-sensitive adhesive layer, so that the adhesion therebetween is lowered to further enhance picking-up efficiencies of the chips.

Subsequently, the IC chips are picked up. As a result of the above work, the pressure-sensitive adhesive layer can remain adhered to each IC chip when the IC chips are separated from the base material.

The IC chips are then mounted on respective die pads via the pressure-sensitive adhesive layers. The die pads have been heated or are heated immediately after the mounting of the IC chips. The heating temperature is generally 80 to 200°C, and preferably 100 to 180°C. The heating time generally ranges from 0.1 sec to 5 min, and preferably from 0.5 sec to 3 min. The chip mounting pressure is generally from 1 kPa to 200 MPa.

Where necessary, further heating may be performed after the IC chips have been mounted on the die pads, under the conditions of the aforesaid heating temperatures and a heating time of 1 to 180 min, and preferably 10 to 120 min.

Through the aforesaid work, the pressure-sensitive adhesive layer is cured and firmly bonds the IC chips and the die pads. Since the pressure-sensitive adhesive layer is fluidized under the die bonding conditions, it can suitably embed therein the irregularities on the die pads to prevent voids.

That is, the semiconductor devices obtained have a constitution in which the pressure-sensitive adhesive layer has been cured to bond the chips and in which the irregularities on the die pads have been densely embedded. This constitution achieves high package reliability and board mounting properties even under severe conditions.

The pressure-sensitive adhesive sheet of the invention may be used in the bonding of other materials such as semiconductor compounds, glass, ceramics and metals.

### EXAMPLES

Hereinbelow, the present invention will be described in detail by the following Examples. However, it should be construed that the invention is in no way limited to the Examples.

In Examples and Comparative Examples, modulus of elasticity, dicing properties, embedding properties at die bonding, bond strength, package reliability and board mounting reliability were evaluated by the following methods.

### [Modulus of elasticity]

A pressure-sensitive adhesive layer was formed in a thickness of 3 mm and thereafter UV irradiated to be partially cured, thereby obtaining a sample for the measurement of modulus of elasticity. The modulus of elasticity of the sample was measured on a rheometer (RDA II manufactured by Rheometrics) at a frequency of 1 Hz and a predetermined temperature.

### [Dicing properties]

When the dicing had been completed in each Example and Comparative Example, the semiconductor chips were observed for flaws or cracks by a light microscope to evaluate the dicing properties.

### [Embedding properties at die bonding]

When the semiconductor chips had been mounted on die pads in each Example and Comparative Example, the interfaces between the pressure-sensitive adhesive layer and die pad were observed for voids by a supersonic flaw detector to evaluate the embedding properties at die bonding.

### [Bond strength]

A silicon wafer was stuck onto the dicing and die bonding pressure-sensitive adhesive sheet of each Example and Comparative Example, and was diced into 10 mm square chips. Thereafter, the chips were mounted on a 10 mm wide rectangular copper plate under the conditions of 120°C, 150 MPa and 1 sec. The mounting was followed by heating at 160°C for 60 min to effect curing. The thus-obtained samples were each set in a universal tensile tester, and a tensile test was made by pulling the chip away from the copper plate at an angle of 90° and a rate of 50 mm/min. The bond strength was obtained as the force required.

### [Package reliability]

The IC packages obtained in each Example and Comparative Example were exposed to 85°C and 60% RH for 168 hr and thereby were caused to adsorb moisture. Subsequently, IR reflow was conducted twice at temperatures up to 260°C. The bonding portions were then observed visually and by a scanning supersonic flaw detector to inspect the occurrerice of lifting or peeling and package cracks.

### [Board mounting reliability]

The IC packages obtained in each Example and Comparative Example were mounted on a motherboard (buildup BT resin wiring board for high density mounting) at 260°C in 1 min.

The motherboard on which the IC packages had been mounted were then thermal shock tested by 1000 cycles of exposure to -40°C and 125°C (one cycle consisted of 1 min heating, 9 min retention of elevated temperature, 1 min cooling and 9 min retention of lowered temperature). After the test, the cross section of the motherboard and IC chips was observed visually and by a scanning supersonic flaw detector to inspect the occurrence of cracks.

### [Pressure-sensitive adhesive layer]

The components of pressure-sensitive adhesive layer employed in Examples and Comparative Examples are:
(A) Pressure-sensitive components
   A1: Copolymer having a weight-average molecular weight of about 200,000 and consisting of 35 parts by mass of butyl acrylate, 20 parts by mass of vinyl acetate, 25 parts by mass of 2-hydroxyethyl methacrylate and 20 parts by mass of glycidyl methacrylate.
   A2: Copolymer having a weight-average molecular weight of about 200,000 and consisting of 65 parts by mass of butyl acrylate, 25 parts by mass of 2-hydroxyethyl methacrylate and 10 parts by mass of glycidyl methacrylate.
   A3: Copolymer having a weight-average molecular weight of about 700,000 and consisting of 35 parts by mass of butyl acrylate, 20 parts by mass of vinyl acetate, 25 parts by mass of 2-hydroxyethyl methacrylate and 20 parts by mass of glycidyl methacrylate.
   A4: Copolymer having a weight-average molecular weight of about 700,000 and consisting of 65 parts by mass of butyl acrylate, 25 parts by mass of 2-hydroxyethyl methacrylate and 10 parts by mass of glycidyl methacrylate.
(B) Thermosetting component
   Mixture consisting of:
   10 parts by mass of a bisphenol A liquid epoxy resin (BPA 328 available from NIPPON SHOKUBAI CO., LTD., epoxy equivalent: 220 to 240 g/eq, molecular weight: about 400);
   40 parts by mass of a solid epoxy resin having a dicyclopentadiene skeleton (EXA 7200HH available from DAINIPPON INK AND CHEMICALS, INCORPORATED, epoxy equivalent: 275 to 280 g/eq, molecular weight: about 800);
   2 parts by mass of a curing agent (ADEKA HARDNER 3636AS available from ASAHI DENKA CO., LTD.); and
   2 parts by mass of a curing accelerator (CUREZOL 2PHZ available from SHIKOKU CHEMICAL CORPORATION).
(C) Thermoplastic resin
   Phenoxy resin (PHENOTOHTO YP50-EK35, available from Tohto Kasei K.K., Tg: 100°C)
(D) Energy ray curing components
   D1: Ultraviolet-curing resin having a dicyclopentadiene skeleton (KAYARAD R-684 available from NIPPON KAYAKU CO., LTD.)
   D2: Photopolymerization initiator (2,4,6-trimethylbenzoyldiphenylphosphine oxide)
(E) Further additives
   E1: silane coupling agent (MKC silicate MSEP2 available from MITSUBISHI CHEMICAL CORPORATION)
   E2: Polyisocyanate crosslinking agent (adduct of trimethylolpropane and toluylene diisocyanate)

### [Examples and Comparative Examples]

### (1) Preparation of dicing and die bonding pressure-sensitive adhesive sheets

The pressure-sensitive adhesive compositions as shown in Table 1 were each applied on a surface of a surface-protective release film that had been release coated with a silicone resin (SP-PET 3811 available from LINTEC CORPORATION, thickness: 38 µm) by means of a roll knife coater, followed by drying so as to form a 20 µm thick adhesive layer. The resultant pressure-sensitive adhesive layer was transferred on a 100 µm thick base material (polyethylene film, surface tension: 32 mN/m) to produce a dicing and die bonding pressure-sensitive adhesive sheet.

### (2) Production of semiconductor chips

Tape mounter (Adwill RAD 2500 available from LINTEC CORPORATION) was employed to stick the dicing and die bonding pressure-sensitive adhesive sheet onto a #2000 polished surface of a silicon wafer (diameter: 100 mm, thickness: 200 µm). The wafer and the adhesive sheet were then fixed with a wafer dicing ring frame (2-6-1 available from DISCO CORPORATION). Subsequently, the pressure-sensitive adhesive layer was UV irradiated through the base material by means of a UV irradiation system (Adwill RAD 2000 available from LINTEC CORPORATION). Thereafter, dicing was performed using a dicing machine (A-WD-4000B available from TOKYO SEIMITSU CO., LTD.) at a chip size of 9.0 mm x 9.0 mm and to a depth of 10 µm below the interface between the pressure-sensitive adhesive layer and the underlying base material. Subsequently, the dicing and die bonding pressure-sensitive adhesive sheet was raised by a needle from underneath, and the chips were picked up so that the separation would take place at the interface between the pressure-sensitive adhesive layer and the base material.

### (3) Production of semiconductor devices

The chips with the pressure-sensitive adhesive layer were each mounted, via the adhesive layer, on a die pad of an IC package substrate and was compression bonded thereto at 120°C and 150 MPa in 1 sec. The IC package substrate used herein was a laminate of a 50 µm polyimide film and a 20 µm electrodeposited copper foil, and had a die pad composed of a gold deposit disposed on a palladium deposit that was patterned on the copper foil, and also had a 25 µm high solder resist. The compression bonding was followed by further heating at 160°C for 60 min to cure the pressure-sensitive adhesive layer. Thereafter, a molding resin (containing biphenyl epoxy resin and phenol novolak resin) was applied on the chip-mounted surface of the substrate and molded the chip in desired shape. The molding resin was then cured by being heated at 175°C for 6 hr, and thereby the chip was high-pressure sealed. Onto the unsealed surface of the substrate, lead-free solder balls having a diameter of 0.5 mm were attached by a given method. Thus, a BGA (ball grid allay) IC package was produced.

The dicing and die bonding pressure-sensitive adhesive sheets and the semiconductor devices obtained above were tested by the aforesaid methods to evaluate their dicing properties, embedding properties at die bonding, bond strengths, package reliability and board mounting reliability. The results are set forth in Table 2.

**Table 1**

| | Pressure-sensitive adhesive layer | | | | | Elastic modulus at 100°C/Elastic modulus at 70° (Pa/Pa) | M₁₀₀/M₇₀ |
|---|---|---|---|---|---|---|---|
| | Pressure-sensitive component (A) | Thermosetting component (B) | Thermoplastic resin (C) | Energy ray curing components (D) | Further additives (E) | | |
| Ex. 1 | A1: 20 parts | 60 parts | 5 parts | D1: 10 parts D2: 1 part | E1: 2 parts E2: 2 parts | 2100/9700 | 0.22 |
| Ex. 2 | A2: 20 parts | 60 parts | 5 parts | D1: 10 parts D2: 1 part | E1: 2 parts E2: 2 parts | 2300/9300 | 0.25 |
| Comp. Ex. 1 | A3: 20 parts | 60 parts | 5 parts | D1: 10 parts D2: 1 part | E1: 2 parts E2: 2 parts | 34700/65900 | 0.53 |
| Comp. Ex. 2 | A4: 20 parts | 60 parts | 5 parts | D1: 10 parts D2: 1 part | E1: 2 parts E2: 2 parts | 36000/63000 | 0.57 |
| Comp. Ex. 3 | A3: 40 parts | 45 parts | - | D1: 10 parts D2: 1 part | E1: 2 parts E2: 2 parts | 53000/75200 | 0.70 |
| Comp. Ex. 4 | A4: 40 parts | 45 parts | - | D1: 10 parts D2: 1 part | E1: 2 parts E2: 2 parts | 59000/79000 | 0.80 |
| Comp. Ex. 5 | A1: 40 parts | 40 parts | 5 parts | D1: 10 parts D2: 1 part | E1: 2 parts E2: 2 parts | 42000/63200 | 0.66 |

| | | | | | | | |
|---|---|---|---|---|---|---|---|
| Parts: parts by mass | | | | | | | |

**Table 2**

| Evaluation items | Ex. | | Comp. Ex. | | | | |
|---|---|---|---|---|---|---|---|
| | 1 | 2 | 1 | 2 | 3 | 4 | 5 |
| Dicing properties | Good | Good | Bad | Bad | Allowable | Allowable | Allowable |
| Embedding properties at die bonding | Good | Good | Bad | Bad | Bad | Bad | Bad |
| Bond strength (N/10 mm) | 8.3 | 8.3 | 7.5 | 7.8 | 2.3 | 1.4 | 3.5 |
| Package reliability | Good | Good | Bad | Bad | Bad | Bad | Bad |
| Board mounting reliability | Good | Good | Bad | Bad | Bad | Bad | Bad |

| | | | | | | | |
|---|---|---|---|---|---|---|---|
| Dicing properties: Good = no flaws or cracks, Bad = flaws or cracks Embedding properties at die bonding: Good = complete embedding, Allowable = partial incomplete embedding, Bad = incomplete embedding | | | | | | | |

### INDUSTRIAL APPLICABILITY

The dicing and die bonding pressure-sensitive adhesive sheet of the invention has the pressure-sensitive adhesive layer that exhibits superior embedding properties with respect to irregularities on the die pads under die bonding conditions. Therefore, the sheet can prevent formation of voids between the die pads and the pressure-sensitive adhesive layer even when chips are mounted on die pads having great difference of height, to thereby contributes to improve production efficiency.

## Claims

1. A dicing and die bonding pressure-sensitive adhesive sheet comprising a base material and a pressure-sensitive adhesive layer disposed thereon, the pressure-sensitive adhesive layer having a ratio (M₁₀₀/M₇₀) of a modulus of elasticity at 100 °C (M₁₀₀) to a modulus of elasticity at 70 °C (M₇₀) being 0.5 or less, wherein the pressure-sensitive adhesive layer comprises a pressure-sensitive component and a thermosetting component, the pressure-sensitive component comprising an acrylic polymer having a weight-average molecular weight of 30,000 to 500,000, and wherein the acrylic polymer contains repeating units derived from vinyl acetate in an amount of 5 to 50% by mass.

2. The dicing and die bonding pressure-sensitive adhesive sheet according to claim 1, wherein the pressure-sensitive adhesive layer further contains a thermoplastic resin having a glass transition temperature of 60 to 150°C.

3. The dicing and die bonding pressure-sensitive adhesive sheet according to claim 2, wherein the weight ratio of the acrylic polymer and the thermoplastic resin (acrylic polymer/thermoplastic resin) ranges from 9/1 to 3/7.

4. The dicing and die bonding pressure-sensitive adhesive sheet according to claim 1, 2 or 3, wherein the base material has a surface tension of 40 mN/m or less at a surface which contacts with the pressure-sensitive adhesive layer.

5. A process for producing semiconductor devices, the process comprising sticking a semiconductor wafer onto the pressure-sensitive adhesive layer of the dicing and die bonding pressure-sensitive adhesive sheet as claimed in any one of claims 1 to 4, dicing the semiconductor wafer into IC chips, picking up the IC chips from the base material while allowing the pressure-sensitive adhesive layer to remain adhered to the IC chips, and bonding the IC chips onto die pads by means of the pressure-sensitive adhesive layer with the application of heat and pressure.

## Patentansprüche

1. Druckempfindliche Klebefolie zum Trennen und Chipverbinden, wobei die druckempfindliche Klebefolie ein Basismaterial und eine darauf angeordnete druckempfindliche Klebeschicht aufweist, wobei die druckempfindliche Klebeschicht ein Verhältnis (M₁₀₀/M₇₀) eines Elastizitätsmoduls bei 100 °C (M₁₀₀) zu einem Elastizitätsmodul bei 70 °C (M₇₀) aufweist, das 0,5 oder weniger beträgt, wobei die druckempfindliche Klebeschicht eine druckempfindliche Komponente und eine wärmeaushärtende Komponente aufweist, wobei die druckempfindliche Komponente ein Acrylpolymer mit einem gewichtsgemittelten Molekulargewicht von 30,000 bis 500,000 aufweist und wobei das Acrylpolymer sich wiederholende Einheiten, die von Vinylacetat abgeleitet sind, in einer Menge von 5 bis 50 Massenprozent enthält.

2. Druckempfindliche Klebefolie zum Trennen und Chipverbinden nach Anspruch 1, **dadurch gekennzeichnet, dass** die druckempfindliche Klebeschicht zusätzlich ein thermoplastisches Harz mit einer Glasübergangstemperatur von 60 bis 150 °C enthält.

3. Druckempfindliche Klebefolie zum Trennen und Chipverbinden nach Anspruch 2, **dadurch gekennzeichnet, dass** das Gewichtsverhältnis des Acrylpolymers und des thermoplastischen Harzes (Acrylpolymer/thermoplastisches Harz) in einem Bereich von 9/1 bis 3/7 liegt.

4. Druckempfindliche Klebefolie zum Trennen und Chipverbinden nach Anspruch 1, 2 oder 3, **dadurch gekennzeichnet, dass** das Basismaterial eine Oberflächenspannung von 40 mN/m oder weniger an einer Oberfläche aufweist, die die druckempfindliche Klebeschicht berührt.

5. Prozess zum Herstellen von Halbleiterbauelementan, wobei der Prozess aufweist: Kleben eines Halbleiterwafers auf die druckempfindliche Klebeschicht der druckempfindlichen Klebefolie zum Trennen und Chipverbinden nach einem der Ansprüche 1 bis 4, Trennen des Halbleiterwafers in IC-Chips. Aufnehmen der IC-Chips von dem Basismaterial, während es der druckempfindlichen Klebeschicht ermöglicht wird, an den IC-Chips haften zu bleiben, und Verbinden der IC-Chips auf Chipauflagen mittels der druckempfindlichen Klebeschicht unter der Anwendung von Wärme und Druck.

## Revendications

1. Feuille adhésive autocollante de découpage en dés et de connexion à la puce comprenant un matériau de base et une couche adhésive autocollante disposée sur celui-ci, la couche adhésive autocollante présentant un rapport (M₁₀₀/M₇₀) entre un module d'élasticité à 100 °C (M₁₀₀) et un module d'élasticité à 70 °C (M₇₀) de 0,5 ou moins, dans laquelle la couche adhésive autocollante comprend un composant autocollant et un composant thermodurcissable, le composant autocollant comprenant un polymère acrylique ayant une masse moléculaire moyenne en masse de 30 000 à 500 000 et dans laquelle le polymère acrylique contient des motifs répétés dérivés de l'acétate de vinyle à une quantité de 5 à 50 % en masse.

2. Feuille adhésive autocollante de découpage en dés et de connexion à la puce selon la revendication 1, dans laquelle la couche adhésive autocollante contient en outre une résine thermoplastique ayant une température de transition vitreuse de 60 à 150 °C.

3. Feuille adhésive autocollante de découpage en dés et de connexion à la puce selon la revendication 2, dans laquelle le rapport en poids entre le polymère acrylique et la résine thermoplastique (polymère acrylique/résine thermoplastique) vaut de 9/1 à 3/7.

4. Feuille adhésive autocollante de découpage en des et de connexion à la puce selon la revendication 1, 2 ou 3, dans lequel le matériau de base présente une tension de surface de 40 mN/m ou moins au niveau d'une surface qui est en contact avec la couche adhésive autocollante.

5. Procédé de production de dispositifs à semi-conducteur, le procédé comprenant le collage d'une tranche de semi-conducteur sur la couche adhésive autocollante de la feuille adhésive autocollante de découpage en dés et de connexion à la puce selon l'une quelconque des revendications 1 à 4, le découpage de la tranche de semi-conducteur en puces de CI, la récupération de puces de CI depuis le matériau de base tout en laissant la couche adhésive autocollante adhérer aux puces de CI, et la connexion des puces de CI sur des plages de connexion de puce au moyen de la couche adhésive autocollante avec application de chaleur et pression.
